(19) Europäisches Patentamt
European Patent Office
Office européen des brevets

(11) EP 0 902 330 A1

(12) EUROPEAN PATENT APPLICATION

(43) Date of publication:
17.03.1999 Bulletin 1999/11

(51) Int. Cl.⁶: **G03F 9/00**

(21) Application number: **98117270.3**

(22) Date of filing: **11.09.1998**

(84) Designated Contracting States:
**AT BE CH CY DE DK ES FI FR GB GR IE IT LI LU MC NL PT SE**
Designated Extension States:
**AL LT LV MK RO SI**

(30) Priority: **16.09.1997 JP 250876/97**

(71) Applicant: **SANEI GIKEN CO., LTD.**
**Amagasaki-shi, Hyogo-ken (JP)**

(72) Inventor:
**Miyake, Eiichi,**
**Sanei Giken Co., Ltd.**
**Amagasaki-shi, Hyogo (JP)**

(74) Representative:
**Prüfer, Lutz H., Dipl.-Phys. et al**
**PRÜFER & PARTNER,**
**Patentanwälte,**
**Harthauser Strasse 25d**
**81545 München (DE)**

(54) **Photomask and alignment method**

(57) A photomask according to the present invention includes first to third alignment marks (4 to 6) for determining a position to transfer a pattern at positions corresponding to sides (2a and 2b) of a substrate (2). Thus, a photomask which permits the phases of patterns to be formed on the top and bottom surfaces of a substrate to be accurately matched and an alignment method therefor are provided.

FIG. 1

## Description

BACKGROUND OF THE INVENTION

Field of the Invention

The present invention relates to photomasks and alignment methods, and more particularly, to a method of aligning a photomask and a substrate by an image processing using an exposure device, and to an alignment mark in a photomask for using sides of a substrate as alignment marks on the substrate side.

The present invention further relates to a method of aligning a top pattern and a bottom pattern to a substrate using a pair of photomasks, one for the top and the other for the bottom including alignment marks while using sides of the substrate as alignment marks on the substrate side.

Description of the Background Art

In recent years, multi-layer circuit substrates formed by layering a plurality of inner substrates having circuit patterns formed on its top and bottom surfaces have been used for printed circuit boards to increase the integration density of the circuits.

The alignment of the top and bottom circuit patterns (hereinafter referred to as "phase") must be accurate in order to accurately provide interconnection between the top and bottom circuit patterns and connect circuit patterns in abutment among the inner substrates layers upon each other.

If circuit patterns are formed on the top and bottom surfaces of an inner substrate, there are following two methods as a method of utilizing sides of the substrate in the process of aligning the inner substrate and a photomask.

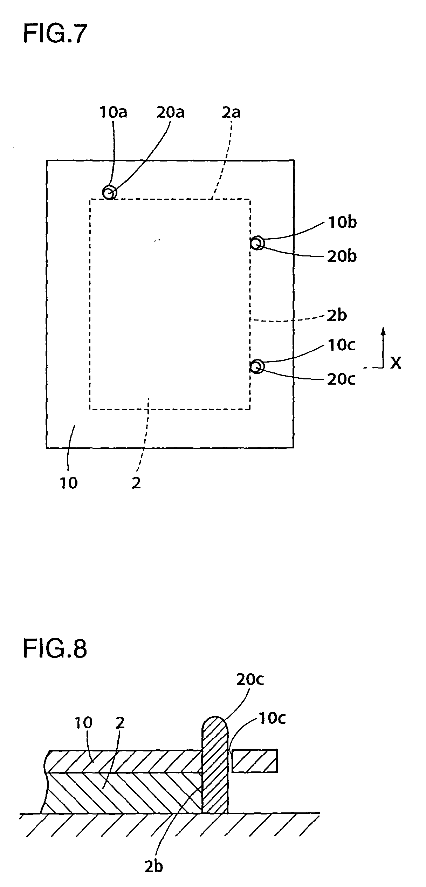

According to a first method, as shown in Figs. 7 and 8, a pin 20a is abutted against a first side 2a of an inner substrate 2, and pins 20b and 20c are abutted against a second side 2b of inner substrate 2 for alignment of inner substrate 2. Then, pins 20a, 20b and 20c are inserted to alignment holes 10a to 10c provided in photomask 10, for alignment of photomask 10. Thus, substrate 2 and photomask 10 may be aligned.

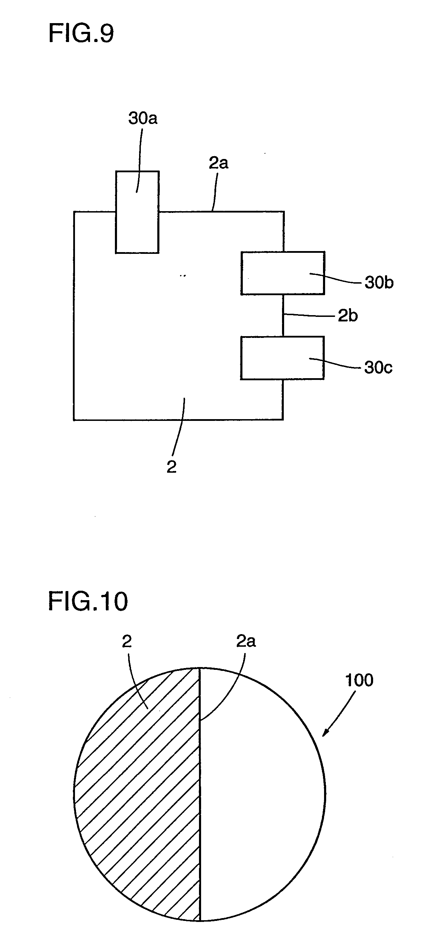

According to a second method, after a photomask is aligned to a CCD camera or a line sensor, as shown in Figs. 9 and 10, inner substrate 2 is aligned using a CCD camera or line sensor 30a for aligning first side 2a of inner substrate 2, and a CCD camera or line sensor 30b, and a CCD camera or line sensor 30c for aligning second side 2b.

The above two methods however suffer from the following problems.

In the first method, since pins 20a, 20b and 20c are inserted to alignment holes 10a to 10c provided in photomask 10, the precision of alignment between photomask 10 and inner substrate 2 cannot be higher than the tolerance for insertion to alignment holes 10a to 10c.

Meanwhile, in the second method, a higher precision is requested for the position and condition of providing the CCD cameras or line sensors than the precision requested for aligning photomask 10 and inner substrate 2, or some correction should be made to the CCD cameras or line sensors, because the processing is basically a one-dimensional processing.

SUMMARY OF THE INVENTION

It is an object of the invention to provide a photomask and a method of alignment according to which the phases of circuit patterns formed on the top and bottom surfaces of an inner substrate may be readily and accurately matched.

A photomask according to the present invention used for transferring circuit patterns to a substrate coated with a photosensitive agent and having first and second sides extending in different directions from each other includes alignment marks for determining the position of transferring the circuit patterns at corresponding positions on the sides of the substrate, the alignment marks include first, second and third alignment marks having a light transmitting portion and a light shielding portion surrounding the light transmitting portion, the first and second alignment marks have their light transmitting portions divided into prescribed amounts by the first side, and the third alignment mark as its light transmitting portion divided into prescribed amounts by the second side of the substrate.

By an alignment method according to the present invention, a photomask used for transferring a circuit pattern to a substrate coated with a photosensitive agent and having first and second sides extending in different directions from each other is aligned to the substrate, first and second alignment marks each having a light transmitting portion and a light shielding portion surrounding the light transmitting portion are provided at positions corresponding to the first side of the substrate, a third alignment mark having a light transmitting portion and a light shielding portion surrounding the light transmitting portion is provided at a position of the photomask corresponding to the second side of the substrate, and the photomask is aligned to the substrate based on the degree of registration of the light transmitting portions of the first, second and third alignment marks on the sides of the substrate.

According to the photomask and the method of alignment according to the invention, the photomask and the substrate are overlaid such that the light transmitting portions of the first and second alignment marks are divided into prescribed amounts by the first side of the substrate, and the photomask may be positioned in the Y-direction along the second side or rotating direction relative to the substrate.

By registering the photomask and the substrate such that the light transmitting portion of the third alignment mark is divided into prescribed amounts by the second side in the above-condition, the photomask may be positioned in the X-direction along the first side relative to the substrate.

The alignment of the photomask to the top and bottom surfaces of the substrate may be enabled in the above-described manner by means of image processing techniques using a CCD camera or the like. As a result, the phases of circuit patterns formed on the top and bottom surfaces of the substrate may be more readily and accurately matched.

The above photomask preferably includes a fourth alignment mark having a light transmitting portion and a light shielding portion surrounding the light transmitting portion, and the fourth alignment mark is positioned such that its light transmitting portion is divided into prescribed amounts by a side opposite to the second side.

In the above alignment method, there is preferably provided a fourth alignment mark having a light transmitting portion and a light shielding portion surrounding the light transmitting portion at a position opposite to the second side of the substrate, and the photomask is aligned to the substrate based on the degree of registration of the light transmitting portions of the first to fourth alignment marks to the sides of the substrate.

According to the photomask and alignment method, by overlaying the photomask and the substrate such that the light transmitting portions of the first and second alignment marks are divided into prescribed amounts by the first side of the substrate, the photomask may be positioned in the Y-direction along the second side and rotating direction, for example, relative to the substrate.

Furthermore, by overlaying the photomask and the substrate such that the degree of registration between the light transmitting portion of the third alignment mark and the second side, and the degree of registration between the light transmitting portion of the fourth alignment mark and a side opposite to the second side of the substrate are the same, the photomask may be positioned in the X-direction along the first side relative to the substrate.

As a result, the photomask may be positioned to the top and bottom surfaces of the substrate by means of an image processing using a CCD camera or the like. The phases of circuit patterns formed on top and bottom surfaces of the substrate may be more readily and accurately matched.

The photomask further preferably has a fifth alignment mark having a light transmitting portion and a light shielding portion surrounding the light transmitting portion, and the fifth alignment mark is provided such that the light transmitting portion of the fifth alignment mark is divided into prescribed amounts by a side positioned opposite to the first side.

In the alignment method, further preferably, a fifth alignment mark having a light transmitting portion and a light shielding portion surrounding the light transmitting portion is provided at a position opposite to the first side, and the photomask and the substrate are aligned based on the degree of registration between the light transmitting portions of the first, second, third, fourth and fifth alignment marks and the sides of the substrate.

Thus, according to the photomask and the method of alignment, by overlaying the photomask and the substrate such that the degree of registration between the light transmitting portions of the first and second alignment marks and the substrate and the degree of registration of the tight transmitting portion of the fifth alignment mark and a side opposite to the first side of the substrate are the same, the photomask may be positioned in the Y-direction along the second side and rotating direction relative to the substrate.

Furthermore, by overlaying the photomask and the substrate such that the degree of registration between the light transmitting portion of the third alignment mark and the second side, and the degree of registration between the light transmitting portion of the fourth alignment mark and the side opposite to the second side of the substrate are the same, the photomask may be positioned in the X-direction along the first side, for example, relative to the substrate.

Consequently, the photomask may be positioned relative to the top and bottom surfaces of the substrate by means of an image processing using a CCD camera, and as a result, the phases of circuit patterns formed on the top and bottom surfaces of the substrate may be more readily and accurately matched.

In the photomask, the alignment mark further preferably has a light non-transmitting region within the light transmitting portion formed by dividing, when the light transmitting portion is positioned to be divided into prescribed amounts by the side of the substrate.

In the photomask, the above alignment mark further preferably has a light non-transmitting region the center of gravity of which is positioned at the center of gravity of a light transmitting portion formed by dividing, when the transmitting portion is positioned to be divided into prescribed amounts by the sides of the substrate.

In the above alignment method, the light transmitting portion of the alignment mark further preferably includes a light not-transmitting region provided at the position of the center of gravity of a semicircle to be a light transmitting portion, when the light transmitting portion of the alignment mark is positioned to be divided into prescribed amounts by the sides of the substrate, and the light transmitting portion of the alignment mark aligns the substrate and the photomask by matching the positions of the centers of gravity of portions to be light transmitting portions.

As described above, according to the photomask and the alignment method, an image processing (calculating area/center of gravity or the like) is enabled in the same field in the same CCD camera, for example, and therefore there is little cause for errors in operations, which is advantageous in terms of precisions.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a schematic diagram for use in illustration of a photomask and an alignment method according to a first embodiment of the invention;

Fig. 2 is a schematic diagram for use in illustration of a photomask and an alignment method according to a second embodiment of the invention;

Fig. 3 is a plan view of alignment marks having a light not-transmitting region at the position of the center of gravity when they are formed into semicircles;

Fig. 4 is a schematic diagram for use in illustration of a photomask and an alignment method according to a third embodiment of the invention;

Figs. 5A, 5B and 5C are first, second and third schematic diagrams for use in illustration of the principle of alignment according to a method of matching "the center of gravity" of a semicircle and the "center of gravity" of the remaining part;

Fig. 6 is a schematic diagram for use in illustration of a photomask and an alignment method thereof according to a fourth embodiment of the present invention.

Fig. 7 is a first diagram for use in illustration of a conventional alignment method;

Fig. 8 is a cross sectional view taken along line X in Fig. 7;

Fig. 9 is a second diagram for use in illustration of the conventional alignment method; and

Fig. 10 is a schematic view showing the state of image processing in Fig. 9.

DESCRIPTION OF THE PREFERRED EMBODIMENTS

Embodiments of a photomask and an alignment method according to the present invention will be now described in conjunction with the accompanying drawings. In the drawings, the same reference characters denote the same or corresponding portions.

First Embodiment

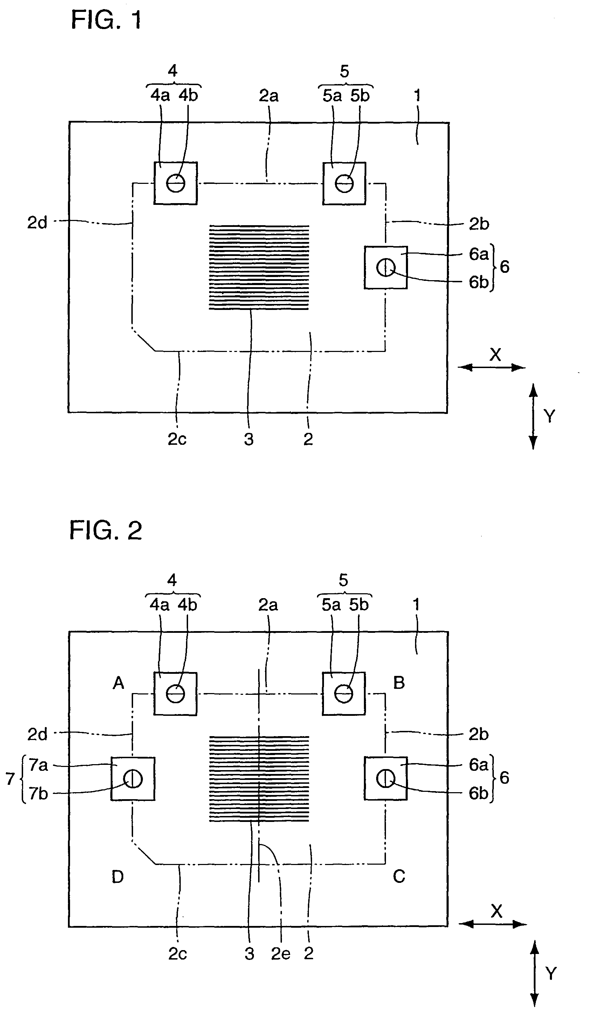

Referring to Fig. 1, a photomask and an alignment method according to a first embodiment of the invention will be described.

A photomask 1 having a prescribed transferred circuit pattern 3 thereon is placed on a square substrate 2. Prescribed circuit patterns are to be formed on the top and bottom surfaces of substrate 2. The material of photomask 1 may be resin or glass depending upon the application.

A plurality of alignment marks for aligning photomask 1 and substrate 2 are provided at prescribed positions on sides of photomask 1 corresponding to the sides (2a, 2b, 2c, 2d) of substrate 2.

In this embodiment, a first alignment mark 4 including a semicircular light transmitting portion 4b, and a light shielding portion 4a formed to surround light transmitting portion 4b is formed at a position corresponding to the side 2a of substrate 2, and a second alignment mark 5 including a light transmitting portion 5b and a light shielding portion 5a formed to surround light transmitting portion 5b is formed at a position a prescribed distance apart from first alignment mark 4. A third alignment mark having a light transmitting portion 6b and a light shielding portion 6a formed to surround light transmitting portion 6b is provided at a position corresponding to the side 2b of substrate 2.

A method of aligning substrate 2 and photomask 1 having first to third alignment marks 4 to 6 as described above will be now described. The images of a region surrounded by the light transmitting portion 4b of first alignment mark 4 and substrate 2, and a region surrounded by the light transmitting portion 5b of second alignment mark 5 and substrate 2 are recognized by an image processing device using a CCD camera or the like, and the positions of the side 2a of substrate 2 and photomask 1 are obtained for matching. The positions of a region surrounded by the light transmitting portion 6b of third alignment mark 6 and substrate 2 is recognized by the image processing device, and the positions of the side 2b of substrate 2 and photomask 1 are obtained for matching.

In the matching, the positions of photomask 1 and substrate 2 are adjusted such that light transmitting portions 4b and 5b are divided into two by side 2a. Thus, the inclination of side 2a (the position of rotation), and the position of side 2a in the Y-direction may be determined. Then, the light transmitting portion 6b of third alignment mark 6 may be positioned to be divided into two by side 2b, in order to determine the position in the X-direction.

Thus, according to the above-described method, photomask 1 and substrate 2 may be aligned by referring to the sides 2a and 2b of substrate 2.

At the time, by providing the light transmitting portions of alignment marks for a photomask for the top surface of substrate 2 and a photomask for the bottom surface of substrate 2 in the same size and at the same position relative to the substrate, at the time of matching between the top surface side photomask and the substrate and the bottom surface side photomask and the substrate, the same segment of the side 2a of substrate 2 appearing within the alignment marks of the photomasks may be used. As a result, the photomasks and the substrate may be aligned using the same information on both top and bottom surfaces.

Thus, the phases of circuit patterns formed on the top and bottom surfaces of a substrate may be readily and accurately matched.

Second Embodiment

Referring to Fig. 2, a photomask and an alignment method according to a second embodiment of the invention will be now described.

A photomask according to the second embodiment, in addition to the alignment marks of the photomask according to the first embodiment, further includes a fourth alignment mark 7 formed at a position corresponding to the side 2d of substrate 2 and having a light transmitting portion 7b and a light shielding portion 7a formed to surround light transmitting portion 7b.

Thus, according to the method of alignment using photomask 1 including first to fourth alignment marks 4 to 7, photomask 1 and substrate 2 are positioned using first alignment mark 4 and second alignment mark 5 in the Y-direction and rotating direction, as is the case with the first embodiment.

Photomask 1 and substrate 2 are aligned so that the degree of registration of the light transmitting portion 6b of third alignment mark 6 and side 2b and the degree of registration of the light transmitting portion 7b of fourth alignment mark 7 and side 2d are the same. Thus, photomask 1 and substrate 2 may be aligned by referring to a virtual central line 2e provided in the middle between sides 2b and 2d.

In this embodiment, as is the case with the first embodiment, alignment by an image processing using a CCD camera or the like may be performed, and the phases of circuit patterns formed on the top and bottom surfaces of a substrate may be more readily and accurately matched.

Third Embodiment

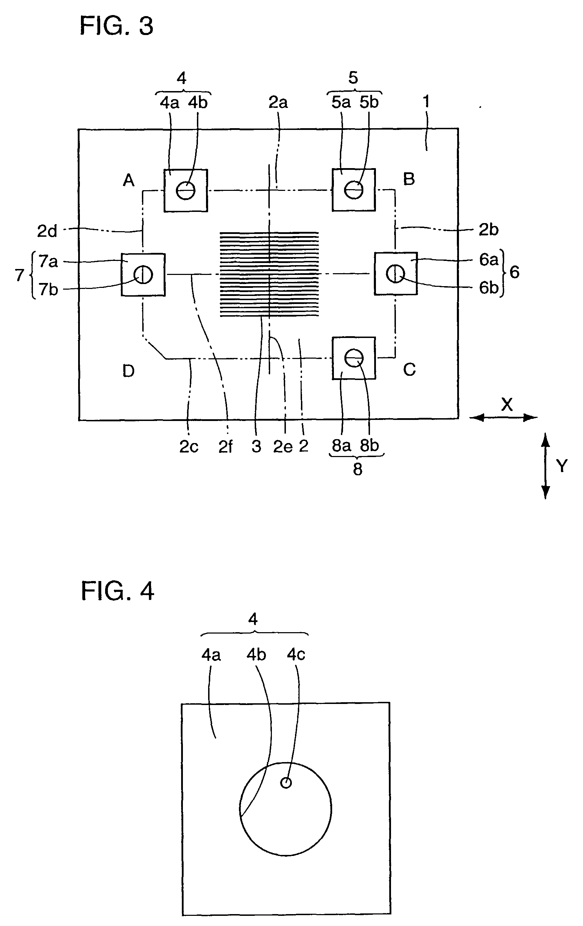

Referring to Fig. 3, a photomask and an alignment method according to a third embodiment of the invention will be now described.

According to the third embodiment, in the photomask according to the second embodiment, a fifth alignment mark 8 is additionally provided at a position corresponding to the side 2c of substrate 2. Fifth alignment mark 8 includes a light transmitting portion 8b and a light shielding portion 8a surrounding light transmitting portion 8b.

In aligning photomask 1 and substrate 2 using a photomask 2 having first to fifth alignment marks 4 to 8, third alignment mark 6 and fourth alignment mark 7 are used for positioning in the X-direction as is the case with the second embodiment shown in Fig. 2.

Then, photomask 1 and substrate 2 are positioned such that the degree of registration between the light transmitting portion 4b of first alignment mark 4 and the light transmitting portion 5b of second alignment mark 5 is equal to the degree of registration between the light transmitting portion 8b of fifth alignment mark 8 and side 2c. Thus, photomask 1 and substrate 2 may be aligned by referring to a virtual central line 2e provided in the middle between sides 2b and 2d and a virtual central line 2f provided in the middle between sides 2a and 2c.

Similarly in this embodiment, alignment using a CCD camera or the like is enabled, the phases of circuit patterns formed on the top and bottom surfaces of a substrate may be more readily and accurately matched.

In addition, in the above embodiments, a photomask and a substrate are aligned based on the degrees of alignment marks and sides of the substrate, but as shown in Fig. 4, a light shielding region 4c may be provided in light transmitting portion 4b, and alignment may be performed based on the positional relation between a light transmitting portion defined by the light transmitting portion and the substrate overlaying each other and the light shielding region.

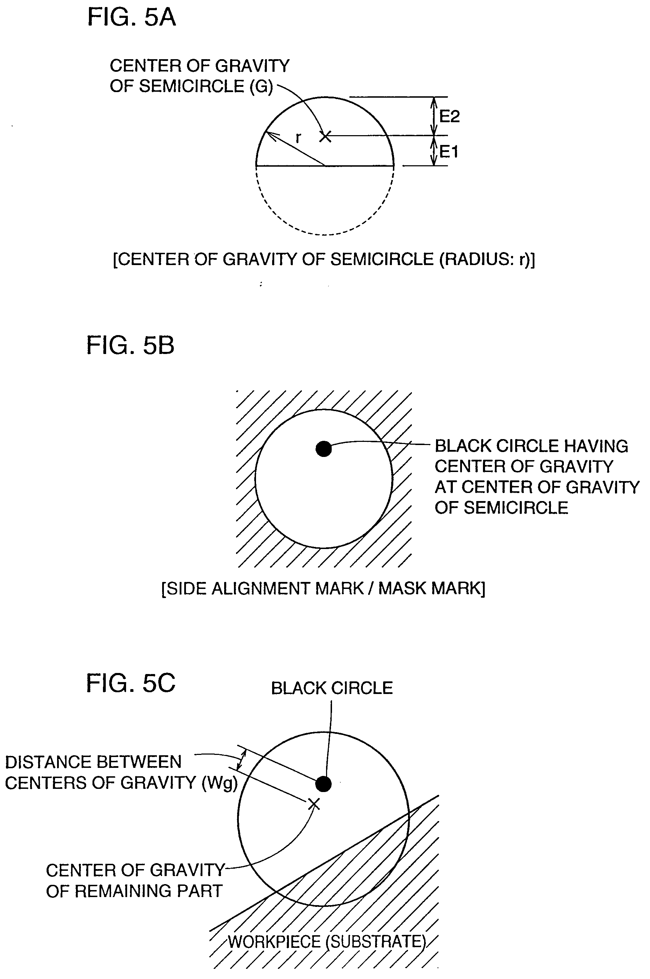

The principle of positioning will be now described. Referring to Fig. 5A, the area of a circle having a radius of r is halved. Now, if the area of the circle is halved, a semicircle having the radius of r is formed. The center of gravity of the semicircle (see Fig. 5B) may be generally represented by the following approximate expressions:

$$E1 \fallingdotseq 0.4244 \times r$$

$$E2 \fallingdotseq 0.5756 \times r$$

Now, if a part of the original circle is arbitrarily linearly masked, the distance between the center of gravity of the remaining light transmitting portion (Fig. 5C) and the center of gravity of the semicircle and their directions may be adjusted to be at prescribed values, such that their positions relative to the line may be controlled at a prescribed degree.

More specifically, by providing a "black circle" having the center of gravity at the center of gravity of the semicircle, the distance between the center of gravities of the black circle and the light transmitting portion and their directions are adjusted. By this method, the following function and effect may be provided.

Since the image processing (such as calculating the area/center of gravity) is performed in the same field of a CCD camera, and therefore there is few cause for errors in operations, which is advantageous in terms of precisions (if, for example, the process of "halving the area" performed by operation from another reference mark, the resolution of the camera, gain or illumination could affect the result, and the effect should be corrected.)

In Figs. 1 to 5C in connection with the foregoing embodiments, the shape of light transmitting portions 4b to 8b is circular, but any shape may be employed if the shape permits the size covered by substrate 2 and the remaining size to be readily operated.

The light transmitting portion and the light non-transmitting portion represent those determined to be light transmitting and non-transmitting as a result of determination of brightness, and if a glass substrate transparent to human eyes is subjected to image-processing as non-light transmitting, the same alignment may be performed. Similarly, the same alignment may be performed by processing images formed by reflected illumination as a light transmitting portion and a non-transmitting portion.

Fourth Embodiment

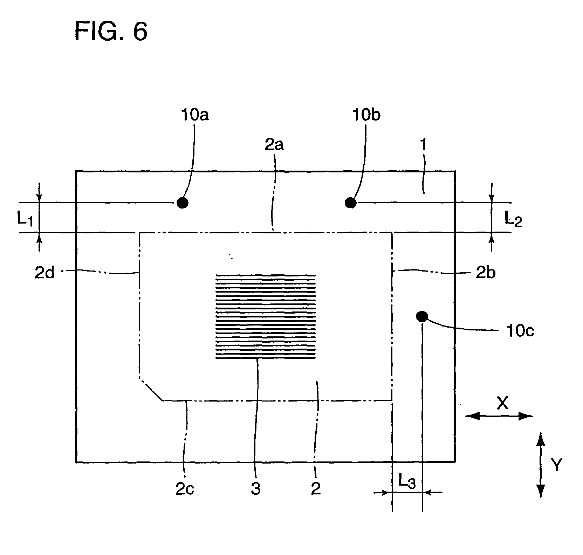

Referring to Fig. 6, a photomask and an alignment method thereof according to a fourth embodiment of the invention will be now described.

Photomask 1 according to the fourth embodiment is provided with a first alignment mark 10a and a second alignment mark 10b at positions corresponding to the side 2a of a substrate 2 applied with a photosensitive agent, and is provided with a third alignment mark 10c at a position corresponding to side 2b.

The pattern shapes of first alignment mark 10a, second alignment mark 10b, and third alignment mark 10c may be any shape as long as the shape may be read by the CCD camera or the like, unlike the case of the embodiments described above.

In the method of aligning photomask 1 to substrate 2, a photosensor of a CCD camera or the like is used to measure the distance L1 between first alignment mark 10a and side 2a, the distance L2 between second alignment mark 10b and side 2a, and the distance between third alignment mark 10c and side 2b, and photomask 1 is aligned to substrate 2 such that distances L1, L2 and L3 are set to predetermined distances.

Thus, the inclination (rotating position) and position in the Y-direction of side 2a may be determined by performing alignment to side 2a at least at two positions. In addition, by performing alignment to side 2b at one position, the position in the X-direction may be determined.

As a result, photomask 1 and substrate 2 may be aligned with reference to the sides 2a and 2b of substrate 2.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A photomask (1) for use in transferring a circuit pattern (3) onto a substrate (2) having first and second sides (2a, 2b) extending in different directions from each other and applied with a photosensitive agent, comprising alignment marks (4, 5, 6) positioned corresponding to said sides (2a, 2b) of said substrate for determining a position to transfer said circuit pattern (3),

   said alignment marks (4, 5, 6) having first, second and third alignment marks each having a light transmitting portion (4b, 5b, 6b) and a light shielding portion (4a, 5a, 6a),
   in said first and second alignment marks (4, 5), said transmitting portions (4b, 5b) being positioned to be divided into prescribed amounts by said first side (2a) of said substrate.

2. The photomask as recited in claim 1, wherein

   in said third alignment mark (6), said light transmitting portion (6b) being positioned to be divided into prescribed amounts by said second side (2b) of said substrate, and/or said light shielding portion (4a, 5a, 6a) surrounding said light transmitting portion (4b, 5b, 6b).

3. The photomask as recited in claim 1 or 2, wherein

   said alignment mark further includes a fourth alignment mark (7) having a light transmitting portion (7b) and a light shielding portion (7a) surrounding light transmitting portion (7b),
   in said fourth alignment mark (7b), said light transmitting portion (7b) being positioned to be divided into prescribed amounts by a side (7d) positioned opposite to said second side (2b) of said substrate, and/or said alignment marks further include a fifth alignment mark (8) having a light transmitting portion (8b) and a light shielding portion (8a) surrounding the light transmitting portion (8b), and
   in said fifth alignment mark (8), said light transmitting portion (8b) is positioned to be divided into prescribed amounts by a side (2e) positioned opposite to said first side (2a) of said substrate.

4. The photomask as recited in one of claims 1 to 3, wherein

   said alignment mark has a non-transmitting legion in said divided light transmitting portion, when said light transmitting portion is positioned to be divided into prescribed amounts by a side of said substrate.

5. The photomask as recited in one of claims 1 to 3, wherein

said alignment mark has a non-transmitting region having a center of gravity at the center of gravity of said divided light transmitting portion, when said light transmitting portion is positioned to be divided into prescribed amounts by a side of said substrate.

6. The photomask as recited in one of claims 1 to 5, wherein

said light transmitting portion and said non-transmitting region are both circular.

7. A method of aligning a photomask (1) for use in transferring a circuit pattern to a substrate (2) having first and second sides (2a, 2b) extending in different directions from each other and applied with a photosensitive agent, comprising the steps of:

providing first and second alignment marks (4, 5) each having a light transmitting portion (4b, 5b) and a light shielding portion (4a, 5a) surrounding the light transmitting portion (4b, 5b) at positions corresponding to said first side (2a) of said substrate (2);
providing a third alignment mark (6) having a light transmitting portion (6b) and a light shielding portion (6a) surrounding the light transmitting portion (6b) at a position corresponding to the second side (2b) of said substrate (2); and
aligning the photomask (1) to said substrate (2) based on the degree of registration between said light transmitting portions (4b, 5b, 6b) of said first, second and third alignment marks (4, 5, 6) and the sides (2a, 2b) of said substrate (2).

8. The method as recited in claim 7, further comprising the steps of:

providing a fourth alignment mark (7) having a light transmitting portion (7b) and a light shielding portion (7a) surrounding the light transmitting portion (7b) at a position corresponding to the second side (2b) of said substrate (2); and
aligning said photomask (1) to said substrate (2) based on the degree of registration between said light transmitting portions of said first, second, third and fourth alignment marks (4, 5, 6, 7) and the sides (2a, 2b) of said substrate (2), and/or
providing a fifth alignment mark (8) having a light transmitting portion (8b) and a light shielding portion (8a) surrounding the light transmitting portion (8b) at a position corresponding to a side (2e) opposite to the first side (2a) of said substrate; and
aligning said photomask (1) to said substrate (2) based on the degree of registration between said light transmitting portions (4b, 5b, 6b, 7b, 8b) of said first, second, third, fourth and fifth alignment marks (4, 5, 6, 7, 8) and the sides (2a, 2b, 2d, 2e) of said substrate (2).

9. The method as recited in claim 7 or 8, wherein

said substrate and said photomask are aligned by adjusting, to a prescribed position, the position of the center of gravity of a non-transmitting portion provided in a transmitting portion formed by dividing said light transmitting portion of said alignment mark into prescribed amounts by a side of said substrate and the position of the center of gravity of a portion to be a light transmitting portion when said light transmitting portion of said alignment mark is divided by said side of said substrate.

10. A method of aligning a photomask (1) to a substrate (2) having first and second sides (2a, 2b) extending in directions different from each other and applied with a photosensitive agent, said photomask (1) being for use in transferring a circuit pattern to said substrate (2),

said photomask (1) having alignment marks (10a, 10b, 10c) at positions outside corresponding sides of said substrate, said alignment marks being provided at least at two positions (10a, 10b) along said first side (2a), and at one position (10c) along said second side (2b),
the method comprising the step of measuring the distance between said first side (2a) and said alignment marks (10a, 10b) corresponding to said first side (2a) and the distance between said second side (2b) and said alignment mark (10c) corresponding to said second side (2b), and aligning said photomask (1) to said substrate (2) based on the measured distance data.

## FIG. 1

## FIG. 2

## FIG. 3

## FIG. 4

## FIG. 5A

CENTER OF GRAVITY
OF SEMICIRCLE (G)

E2

E1

r

[CENTER OF GRAVITY OF SEMICIRCLE (RADIUS: r)]

## FIG. 5B

BLACK CIRCLE HAVING
CENTER OF GRAVITY
AT CENTER OF GRAVITY
OF SEMICIRCLE

[SIDE ALIGNMENT MARK / MASK MARK]

## FIG. 5C

BLACK CIRCLE

DISTANCE BETWEEN
CENTERS OF GRAVITY (Wg)

CENTER OF GRAVITY
OF REMAINING PART

WORKPIECE (SUBSTRATE)

## FIG. 6

# FIG.7

10a    20a    2a

10b
20b

2b

10c
X
20c

10    2

# FIG.8

20c
10    2    10c

2b

FIG.9

30a

2a

30b

2b

30c

2

FIG.10

2

2a

100

**European Patent Office**

**EUROPEAN SEARCH REPORT**

Application Number

EP 98 11 7270

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 4 318 003 A (ONO YOSHIO ET AL) 2 March 1982 * column 2, line 59 - column 3, line 10; figures 4-6 * | 1-10 | G03F9/00 |
| X | US 4 370 059 A (MASUDA TATSUNOSUKE) 25 January 1983 * the whole document * | 1-10 | |
| X | EP 0 626 623 A (SGS THOMSON MICROELECTRONICS) 30 November 1994 * column 3, line 12 - line 21; figures 4,5 * | 1 | |
| A | DE 25 16 210 A (INOUE YOSHIO) 6 November 1975 | | |
| A | WO 94 02807 A (OPTICAL RADIATION CORP) 3 February 1994 | | |

**TECHNICAL FIELDS SEARCHED (Int.Cl.6)**

G03F

The present search report has been drawn up for all claims

| Place of search | Date of completion of the search | Examiner |
|---|---|---|
| THE HAGUE | 19 January 1999 | Haenisch, U |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

ANNEX TO THE EUROPEAN SEARCH REPORT
ON EUROPEAN PATENT APPLICATION NO.

EP 98 11 7270

This annex lists the patent family members relating to the patent documents cited in the above-mentioned European search report.
The members are as contained in the European Patent Office EDP file on
The European Patent Office is in no way liable for these particulars which are merely given for the purpose of information.

19-01-1999

| Patent document cited in search report | | Publication date | Patent family member(s) | | Publication date |
|---|---|---|---|---|---|
| US 4318003 | A | 02-03-1982 | JP | 1472492 C | 27-12-1988 |
| | | | JP | 55108666 A | 21-08-1980 |
| | | | JP | 63021183 B | 06-05-1988 |
| | | | JP | 1421909 C | 29-01-1988 |
| | | | JP | 55138746 A | 29-10-1980 |
| | | | JP | 62030425 B | 02-07-1987 |
| | | | DE | 3004888 A | 21-08-1980 |
| | | | FR | 2449298 A | 12-09-1980 |
| | | | GB | 2043924 A,B | 08-10-1980 |
| | | | US | 4426152 A | 17-01-1984 |
| | | | DE | 3014391 A | 23-10-1980 |
| | | | FR | 2454645 A | 14-11-1980 |
| | | | GB | 2052096 A,B | 21-01-1981 |
| US 4370059 | A | 25-01-1983 | JP | 1222045 C | 15-08-1984 |
| | | | JP | 55033145 A | 08-03-1980 |
| | | | JP | 58056402 B | 14-12-1983 |
| | | | DE | 2934454 A | 13-03-1980 |
| | | | FR | 2435081 A | 28-03-1980 |
| | | | GB | 2034881 A,B | 11-06-1980 |
| EP 0626623 | A | 30-11-1994 | FR | 2704660 A | 04-11-1994 |
| | | | US | 5604354 A | 18-02-1997 |
| DE 2516210 | A | 06-11-1975 | JP | 1214502 C | 27-06-1984 |
| | | | JP | 50137204 A | 31-10-1975 |
| | | | JP | 58036333 B | 09-08-1983 |
| | | | GB | 1502825 A | 01-03-1978 |
| | | | US | 3974374 A | 10-08-1976 |
| WO 9402807 | A | 03-02-1994 | US | 5337151 A | 09-08-1994 |
| | | | AU | 4994593 A | 14-02-1994 |

EPO FORM P0459

For more details about this annex : see Official Journal of the European Patent Office, No. 12/82